# EUROPEAN PATENT APPLICATION

(11) **EP 1 056 324 A2**
(43) Date of publication of application: **29.11.2000**
(21) Application number: 00304394.0
(22) Date of filing: 24.05.2000
(51) Int. Cl.: H05K 9/00, H01J 11/02

(54) **Light transmitting laminated plate for electromagnetic shielding**

(30) Priority: 28.05.1999 JP 15013499; 28.05.1999 JP 15013699
(71) Applicant: Bridgestone Corporation, Tokyo (JP)
(72) Inventor: Yoshikawa, Masato, Kodaira-shi, Tokyo (JP); Ono, Shingo, Kodaira-shi, Tokyo (JP); Sugimachi, Masato, Kodaira-shi, Tokyo (JP); Morimura, Yasuhiro, Kodaira-shi, Tokyo (JP)
(74) Representative: Jenkins, Peter David

(57) **Abstract**

An electromagnetic-wave shielding and light transmitting plate or a panel laminated plate is formed by interposing an electromagnetic-wave shielding and heat ray blocking layer between two transparent base plates or between a transparent base plate and a PDP body and integrally bonding them together by adhesive intermediate films. The electromagnetic-wave shielding and heat ray blocking film is made by laminating oxide transparent conductive films and metal thin films in nine layers on a base film, or further laminating a titanium nitride film and an oxide transparent conductive film on a multi-layered film composed of oxide transparent conductive films and metal thin films on a base film.

## Description

The present invention relates to an electromagnetic-wave shielding and light transmitting plate and a panel laminated plate and, more particularly, to an electromagnetic-wave shielding and light transmitting plate suitable for a front filter of a PDP (plasma display panel), which has good electromagnetic-wave shielding capability, heat ray (near infrared ray) blocking capability, and light transmitting capability, and a panel laminated plate of a gas discharge type in which a PDP is integrated with an electromagnetic-wave shielding and heat ray blocking member to impart electromagnetic-wave shielding capability and heat ray blocking capability to the panel laminated plate itself, thereby lightening its weight, reducing its thickness, reducing the number of parts, and thus improving the productivity and reducing the cost.

With the spread of electronic appliances including office automation apparatuses and communication instruments, electromagnetic wave emission from these appliances have come into a problem. That is, adverse effect of electromagnetic wave to the human body is feared and it is also a problem that the electromagnetic wave affects precision apparatus to cause malfunction. Therefore, plates having good electromagnetic-wave shielding efficiency and light transparency have developed as front filters for PDPs of the office automation apparatuses and come into commercial use. Such plates are also used as windows of a place where a precision apparatus is installed, such as a hospital or a laboratory in order to protect the precision apparatus from electromagnetic waves form a portable telephone.

A conventional electromagnetic-wave shielding and light transmitting plate typically comprises transparent base plates such as acrylic boards and a conductive mesh member like a wire netting and is formed by interposing the conductive mesh member between the transparent base plates and by assembling them.

The applicant of this application has proposed an electromagnetic-wave shielding and light transmitting plate, having improved characteristics and allowing easier handling as compared with the conventional one, in which a conductive mesh member is interposed between two transparent base plates and integrally bonded together by transparent adhesives (JPA 11-74683).

The applicant of this application has proposed an electromagnetic-wave shielding, heat ray blocking and light transmitting plate, having high transparency, improved electromagnetic-wave shielding capability and heat ray blocking capability, which comprises two transparent base plates and a multi-layered film as an intermediate film interposed between the transparent base plates which are integrally bonded together by transparent adhesives, wherein the multi-layered film is composed of oxide transparent conductive films and metal thin films which are alternatively laminated (JPA 11-97880).

The multi-layered film composed of the oxide transparent conductive films and the metal thin films which are alternatively laminated can provide good electromagnetic-wave shielding efficiency and good heat ray (near infrared ray) blocking efficiency without losing the transparency.

On the other hand, a PDP utilizing a discharging phenomenon has the following advantages in comparison to a liquid crystal display (LCD) and a cathode ray tube (CRT). Therefore, recently it has been researched and developed for practical use, for example, televisions, office automatic apparatus such as personal computers and word processors, traffic apparatus, boards, and other kinds of display panels.
1. It utilizes discharge light so that it is spontaneous light.
2. As its discharge gap is 0.1-0.3 mm, it can be shaped in panel.
3. By using fluorescent substances, it can emit colors.
4. It eases to make wide screen.

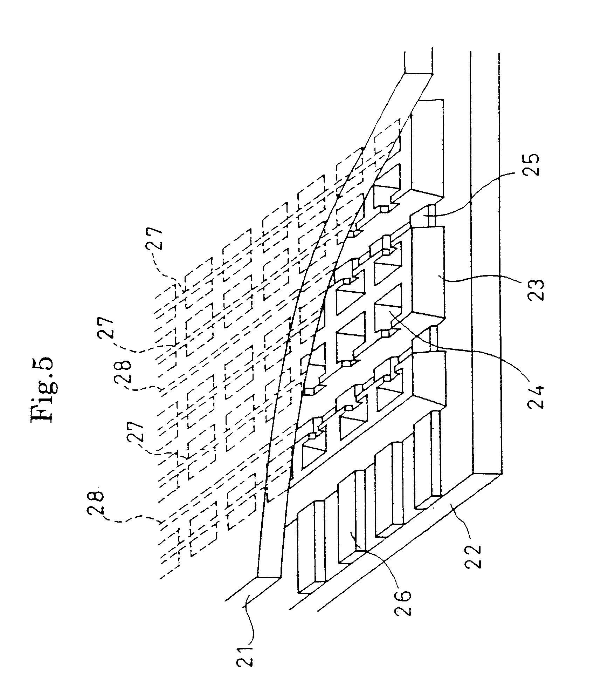

The basic display mechanism of the PDP is displaying of letters and figures by selective discharge emitting of fluorescent substances in many discharge cells which are disposed distantly each other between two plate glasses, and for example, has a mechanism as shown in Fig. 5.

In Fig. 5, a numeral 21 designates a front glass, 22 designates a rear glass, 23 designates a bulkhead, 24 designates a display cell (discharge cell), 25 designates an auxiliary cell, 26 designates a cathode, 27 designates a display anode, 28 designates an auxiliary anode. A red fluorescent substance, a green fluorescent substance, or a blue fluorescent substance (not shown) is provided in a film form on internal walls of each display cell 24 and these fluorescent substances emit light by electrical discharges when a voltage is applied between electrodes.

From the front surface of the PDP, electromagnetic waves with frequency from several kHz to several GHz are generated due to applying voltage electrical discharge, and light emission, and the electromagnetic waves have to be shielded.

Moreover, for improving its display contrast, reflection of external light at the front surface has to be prevented.

The PDP which the separate transparent plate is disposed in front of the PDP has defects as follows:
1. Structure for disposing two panels is complicated.
2. As a transparent base plate made of glass or the like is required for each of the PDP and the electromagnetic-wave shielding transparent plate, the PDP and the electromagnetic-wave shielding transparent plate make thicker and heavier in total.
3. The number of parts and man-hours are increased, thereby raising the cost.

To solve the aforementioned problems and to provide a display panel of a panel laminated plate in which a PDP is integrally bonded to an electromagnetic-wave shielding member to impart electromagnetic-wave shielding capability to the panel laminated plate itself, thereby lightening its weight, reducing its thickness, reducing the number of parts, and thus improving the productivity and reducing the cost and, further, to impart near infrared ray blocking capability in addition to the electromagnetic-wave shielding capability, the applicant of this application has previously proposed a display panel comprising a PDP body, an electromagnetic-wave shielding member bonded to a front surface of the PDP body by transparent adhesives, a transparent base plate bonded to a front surface of the electromagnetic-wave shielding member by transparent adhesives, which is characterized by further comprising a heat-ray blocking layer interposed between the transparent base plate and the PDP body (JPA 11-119666).

In the display panel of JPA 11-119666, the PDP, the electromagnetic-wave shielding member, the heat-ray blocking layer, and the transparent base plate are integrally bonded together by transparent adhesives, thereby lightening its weight, reducing its thickness, reducing the number of parts, and thus improving the productivity and reducing the cost. In addition, the heat-ray blocking layer is also integrally laminated on the electromagnetic-wave shielding member, thereby obtaining excellent near infrared ray blocking efficiency.

In the electromagnetic-wave shielding and light transmitting plate and the panel laminated plate, the near infrared ray blocking capability is a very-important required characteristic for the purpose of securely preventing the malfunction of a remote controller. In particular, since the producing rate of near infrared ray is increased with the improvement of brightness of PDP, further improved near infrared ray blocking capability is desired.

On the other hand, in view of simplifying the structure to simplify the manufacturing process, reduce the manufacturing cost, and improve the production efficiency, a transparent conductive film is advantageous in using as an electromagnetic-wave shielding member as compared with a conductive mesh member.

By employing the multi-layered film composed of the oxide transparent conductive films and the metal thin films which are alternatively laminated to have electromagnetic-wave shielding capability and heat ray blocking capability as disclosed in JPA 11-97880, electromagnetic-wave shielding capability and heat ray blocking capability can be obtained by interposing the multi-layered film between the base plates without using a conductive mesh member, but it is hard to say that the capabilities are enough. Therefore, it is desired to provide an electromagnetic-wave shielding and light transmitting plate and a panel laminated plate having further improved electromagnetic-wave shielding capability and heat ray blocking capability, and having high transparency in a range of visible radiation, thereby displaying distinct pictures.

The multi-layered film composed of the oxide transparent conductive films and the metal thin films which are alternatively laminated has a problem of decreasing the ratio of transmitting images to a display and decreasing the contrast due to high reflectance in a range of visible radiation of metal thin films made of silver or the like.

It is an aim of the present invention to provide an electromagnetic-wave shielding and light transmitting plate and a panel laminated plate integrated with PDP having significantly improved electromagnetic-wave shielding capability and heat ray blocking capability, and having high transparency in a range of visible radiation, thereby displaying distinct pictures.

It is another object of the present invention to provide an electromagnetic-wave shielding and light transmitting plate and a panel laminated plate integrated with PDP which can solve the problems of the aforementioned conventional multi-layered film and has significantly improved electromagnetic-wave shielding capability and heat ray blocking capability, and has anti-reflection capability and high transparency in a range of visible radiation, thereby displaying distinct pictures.

An electromagnetic-wave shielding and light transmitting plate according to a first aspect of the present invention comprises two transparent base plates and an electromagnetic-wave shielding and heat ray blocking layer interposed between the transparent base plates and integrally bonded together by transparent adhesives, wherein said electromagnetic-wave shielding and heat ray blocking layer is a nine-layered film made by alternatively laminating oxide transparent conductive films and metal thin films in which the top layer is one of the oxide transparent conductive films.

A panel laminated plate of a second aspect of the present invention comprises a plasma display panel body, a transparent base plate, and an electromagnetic-wave shielding and heat ray blocking layer interposed between the front surface of the plasma display panel body and the transparent base plate and integrally bonded together by transparent adhesives, wherein said electromagnetic-wave shielding and heat ray blocking layer is a nine-layered film made by alternatively laminating oxide transparent conductive films and metal thin films in which the top layer is one of the oxide transparent conductive films.

According to the present invention, the electromagnetic-wave shielding and heat ray blocking layer is composed of a nine-layered film of an oxide transparent conductive film/ a metal thin film/ an oxide transparent conductive film/ a metal thin film/ an oxide transparent conductive film/ a metal thin film/ an oxide transparent conductive film/ a metal thin film/ an oxide transparent conductive film, thereby providing an electromagnetic-wave shielding and light transparent plate or a panel laminated plate having high transparency, significantly improved electromagnetic-wave shielding capability and heat ray blocking capability.

An electromagnetic-wave shielding and light transmitting plate according to a third aspect of the present invention comprises two transparent base plates and an electromagnetic-wave shielding and heat ray blocking layer interposed between the transparent base plates and integrally bonded together by transparent adhesives, wherein said electromagnetic-wave shielding and heat ray blocking layer comprises a multi-layered film, made by alternatively laminating oxide transparent conductive films and metal thin films in such a manner that the front-most layer of the resultant plate is one of the oxide transparent conductive films, in addition, a titanium nitride film formed on the multi-layered film, and further another oxide transparent conductive film formed on the titanium nitride film.

A panel laminated plate according to a fourth aspect of the present invention comprises a plasma display panel body, a transparent base plate, and an electromagnetic-wave shielding and heat ray blocking layer interposed between the front surface of the plasma display panel body and the transparent base plate and integrally bonded together by transparent adhesives, wherein said electromagnetic-wave shielding and heat ray blocking layer comprises a multi-layered film, made by alternatively laminating oxide transparent conductive films and metal thin films in such a manner that the front-most layer of the resultant plate is one of the oxide transparent conductive films, in addition, a titanium nitride film formed on the multi-layered film, and further another oxide transparent conductive film formed on the titanium nitride film.

According to the present invention, in the multi-layered film of oxide transparent conductive films and metal thin films of the electromagnetic-wave shielding and heat ray blocking layer, the top metal thin film is replaced by a titanium nitride film, thereby providing an electromagnetic-wave shielding and light transparent plate or a panel laminated plate in which the reflectance in the visible light range is reduced without losing conductivity and which has high transparency, significantly improved electromagnetic-wave shielding capability and heat ray blocking capability.

In the present invention, the electromagnetic-wave shielding and heat ray blocking layer is preferably composed of an electromagnetic-wave shielding and heat ray blocking film made by forming the electromagnetic-wave shielding and heat ray blocking layer on a base film.

When normal adhesives are used for the integration, there is a safety problem that fragments of the electromagnetic-wave shielding and light transmitting plate or the panel laminated plate are scattered when receiving an impact. However, since transparent elastic adhesives are used as the transparent adhesives, the scattering of fragments when damaged can be prevented, thereby improving the safety.

Embodiments of the present invention are described hereunder, by way of example only, with reference to the accompanying drawings, in which:-
Fig. 1 is a sectional view schematically showing an embodiment of an electromagnetic-wave shielding and light transmitting plate of the present invention;
Fig. 2 is a sectional view schematically showing an embodiment of a panel laminated plate of the present invention;
Fig. 3 is a sectional view schematically showing an embodiment of an electromagnetic-wave shielding and heat ray blocking film according to the present invention;
Fig. 4 is a sectional view schematically showing another embodiment of the electromagnetic-wave shielding and heat ray blocking film according to the present invention; and
Fig. 5 is a partially perspective cut-way view showing the structure of a typical PDP.

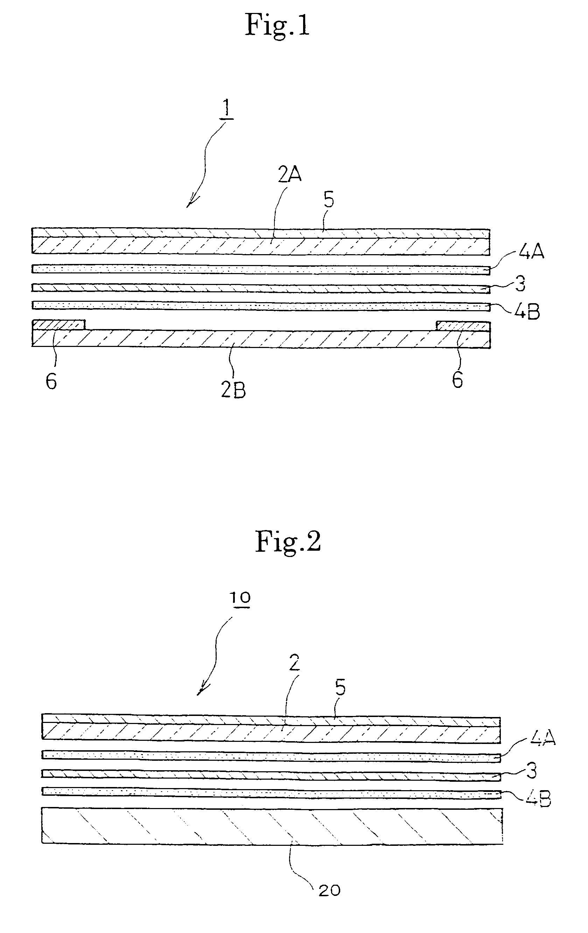

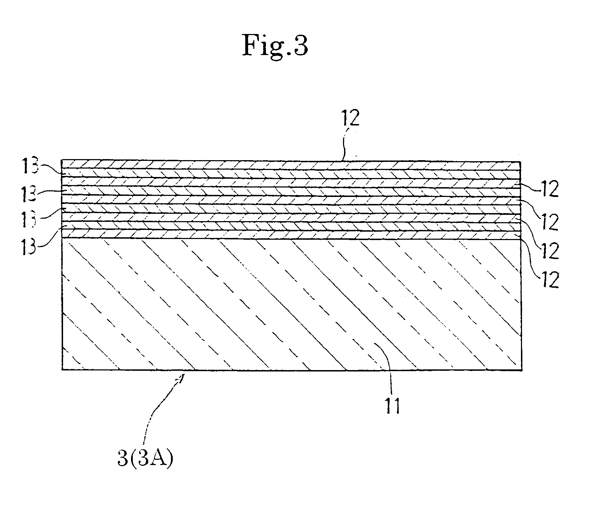

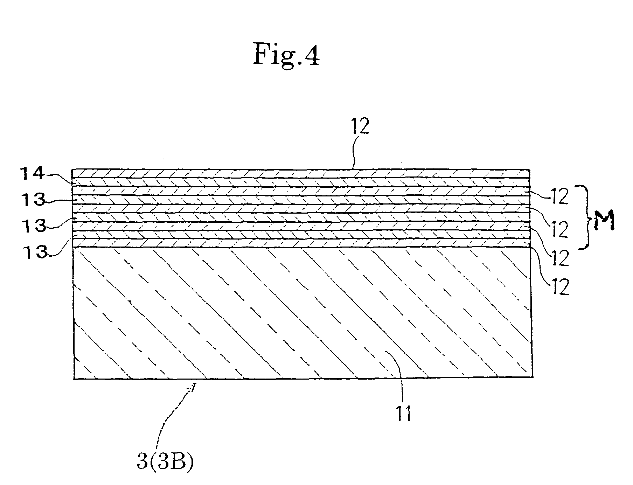

Figs. 1, 2 are sectional views schematically showing respective embodiments of an electromagnetic-wave shielding and light transmitting plate and a panel laminated plate of the present invention. Figs. 3, 4 are sectional views schematically showing embodiments of the electromagnetic-wave shielding and heat ray blocking film according to the present invention.

The electromagnetic-wave shielding and light transmitting plate 1 of Fig. 1 includes an electromagnetic-wave shielding and heat ray blocking film 3 which is interposed between two transparent base plates 2A, 2B and integrally bonded together with adhesive intermediate films 4A, 4B as adhesives.

The panel laminated plate 10 shown in Fig. 2 includes an electromagnetic-wave shielding and heat ray blocking film 3 which is interposed between a transparent base plate 2 and a PDP body 20 (any of typical PDPs such as the PDP having the structure as shown in Fig. 5 is applicable) and integrally bonded together with adhesive intermediate films 4A, 4B similar to those of the embodiment of Fig 1 and other structures of the panel laminated plate 10 are the same as those of the electromagnetic-wave shielding and light transmitting plate 1 of Fig 1.

In the present invention, examples of material of the transparent base plates 2A, 2B, 2 include glass, polyester, polyethylene terephthalate (PET), polybutylene terephthalate, polymethyl methacrylate (PMMA), acrylic board, polycarbonate (PC), polystyrene, triacetate film, polyvinyl alcohol, polyvinyl chloride, polyvinylidene chloride, polyethylene, ethylene-vinyl acetate copolymer, polyvinylbutyral, metal ionic cross-linked ethylene-methacrylic copolymer, polyurethane, and cellophane. Preferably selected from the above materials are glass, PET, PC, and PMMA.

The thicknesses of the transparent base plates 2A, 2B, 2 are suitably determined in accordance with requirements (e.g. strength, light weight) due to the application of a plate to be obtained and are normally in a range from 0.1 to 10 mm.

The transparent base plates 2A, 2B are not necessarily made of the same material. For example, in a case of a PDP front filter of which only the front surface is required to have scratch resistance and durability, the transparent base plate 2A as the front surface may consist of a glass plate having a thickness of 0.1 to 10 mm and the transparent base plate 2B as the rear surface (at the electromagnetic wave source side) may consist of a PET film or PET board, an acrylic film or acrylic board, or a polycarbonate film or polycarbonate board having a thickness of 1 µm to 10 mm.

In the electromagnetic-wave shielding and light transmitting plate 1 of this embodiment, acrylic resin-based black painting 6 is provided in a flame shape on the peripheral portion of the rear surface of the transparent base plate 2B.

In the electromagnetic-wave shielding and light transmitting plate 1 and the panel laminated plate 10 of these embodiments, an antireflection film 5 is formed on the surface of the transparent base plate 2A, 2 as the front surface. The antireflection film 5 formed on the surface of the transparent base plate 2A, 2 is a film or a laminated film of a high-refractive transparent film and a low-refractive transparent film and examples of the film or the laminated films are as follows:
( 1 ) a flim consisting of a rower-refractive transparent film than the transparent face plate;
( 2 ) a laminated film consisting of a high-refractive transparent film and a low-refractive transparent film, i.e. two films in amount;
( 3 ) a laminated film consisting of two high-refractive transparent films and two low-refractive transparent films which are alternately laminated, i.e. four films in amount;
( 4 ) a laminated film consisting of a medium-refractive transparent film, a high-refractive transparent film, and a low-refractive transparent film, i.e. three films in amount; and
( 5 ) a laminated film consisting of three high-refractive transparent films and three low-refractive transparent films which are alternately laminated, i.e. six films in amount.

As the high-refractive transparent film, a film, preferably a transparent conductive film, having a refractive index of 1.8 or more can be made of ZnO, TiO₂, SnO₂, or ZrO in which ITO (tin indium oxide) or ZnO, A1 is doped. On the other hand, as the low-refractive transparent film, a film can be made of low-refractive material having a refractive index of 1.6 or less such as SiO₂, MgF₂, or Al₂O₃. The thicknesses of the films vary according to the film structure, the film kind, and the central wavelength because the refractive index in a visible-light area is reduced by interference of light. In case of four-layer structure, the antireflection film is formed in such a manner that the first layer (high-refractive transparent film) is from 5 to 50 nm, the second layer (low-refractive transparent film) is from 5 to 50 nm, the third layer (high-refractive transparent film) is from 50 to 100 nm, and the fourth layer (low-refractive transparent film) is from 50 to 150 nm in thickness.

The antireflection film 5 may be further formed with an antifouling film to improve the fouling resistance of the surface. The antifouling film is preferably a fluorocarbon or silicone film having a thickness in a range from 1 to 1000 nm.

In the electromagnetic-wave shielding and light transmitting plate and the panel laminated plate of the present invention, the transparent base plate 2A or 2 as the front surface may be processed by hard coating with material of silicone series and/or anti- glare finish by hard coating including light-scattering agent to improve its function. In addition, the aforementioned anti-reflection film, the hard coating film, and/or the anti-glare film may be attached to the transparent base plate 2A or 2 with transparent sticker or transparent adhesives. On the other hand, the transparent base plate 2B as the rear surface may be processed by heat ray reflection coating with a metallic film or a transparent conductive film to improve its function. Such a transparent conductive film may be formed on the transparent base plate 2A, 2 as the front surface.

The electromagnetic-wave shielding and heat ray blocking film 3 (3A) according to the first and second aspects of the present invention includes a base film 11, oxide transparent conductive films 12 and the metal thin films 13 which are alternatively laminated to form a nine-layered film, the nine-layered film being disposed on the base film. 11 as shown in Fig 3.

If the number of layers is less than nine, enough electromagnetic-wave shielding capability and heat ray blocking capability can not be obtained. On the other hand, if the number of layers is more than nine, the transparency is lost and thus not preferable.

The electromagnetic-wave shielding and heat ray blocking film 3 (3B) according to the third and fourth aspects of the present invention includes a base film 11, oxide transparent conductive films 12 and the metal thin films 13 which are alternatively laminated to form a multi-layered film on the base film, a titanium nitride (TiNx) film 14 formed on the multi-layered film, and further another oxide transparent conductive film 12 formed on the titanium nitride film 14 as shown in Fig. 4. It should be noted that the top oxide transparent conductive film 12 side is the front side (visual side) of the resultant plate or panel laminated plate.

In the electromagnetic-wave shielding and heat ray blocking films 3A, 3B, the base film 11 is a resin film made of one of the aforementioned materials for the transparent base plate and is preferably made of PET, PC, PMMA, or the like. The thickness of this film is preferably in a range between 1 µm and 5 mm to prevent the thickness of the resultant display panel from being too thick to ensure its easy handling and its durability.

As the oxide transparent conductive film 12 which is formed on this base film 11, a thin film made of, for example, ITO, ZnO, ZnO in which Al is doped, and SnO₂ may be formed and its thickness is usually in a range of 5-5000 Å.

And as the metal thin film 13, a pure thin film such as silver, copper, aluminum, nickel, gold, platinum, and chromium or an alloy thin film such as brass, stainless steel may be formed in such a thickness as not to lose its light transmitting capability and the thickness therefore is usually in a range of 2-2000Å.

In the electromagnetic-wave shielding and heat ray blocking film 3B of Fig. 4, the number of layers of the multi-layered portion (indicated by "M" in Fig. 4) composed of the oxide transparent conductive films 12 and the metal thin films 13 is preferably in a range from three to nineteen, more preferably, five, seven, or nine in view of the electromagnetic-wave shielding capability, the heat ray blocking capability, and the transparency.

The thickness of the titanium nitride film 14 formed on the multi-layered portion M is preferably in a range of 2-2000Å.

The titanium nitride film 14 is not limited to one layer. A plurality of titanium nitride films 14 and a plurality of oxide transparent conductive films 12 may be alternatively laminated.

These oxide transparent conductive films 12, the metal tin films 13, and the titanium nitride film 14 can be formed easily on the base film 11 by one of methods including sputtering, vacuum evaporation, ion plating, and CVD (chemical vapor deposit). Among them, sputtering by which it is easy to control the thickness is preferable.

According to the present invention, in addition to the electromagnetic-wave shielding and heat ray blocking film, a transparent conductive film may be interposed between the transparent base plates or between the transparent base plate and the PDP body. In this case, the transparent conductive film may be a resin film comprising a resin film in which conductive particles are dispersed or a base film on which a transparent conductive layer is formed.

The conductive particles may be any particles having conductivity and the following are examples of such conductive particles.
(i) carbon particles or powder;
(ii) particles or powder of metal such as nickel, indium, chromium, gold, vanadium, tin, cadmium, silver, platinum, aluminum, copper, titanium, cobalt, or lead, alloy thereof, or conductive oxide thereof; and
(iii) particles made of plastic such as polystyrene and polyethylene, which are surfaced with coating layer of a conductive material from the above (i) and (ii).

Because the conductive particles of large particle diameter affect the light transparency and the thickness of the transparent conductive film, it is preferable that the particle diameter is 0.5 mm or less. The preferable particle diameter of the conductive particles is between 0.01 and 0.5 mm.

The high mixing ratio of the conductive particles in the transparent conductive film spoils the light transparency, while the low mixing ratio makes the electromagnetic-wave shielding efficiency short. The mixing ratio of the conductive particles is therefore preferably between 0.1 and 50 % by weight, particularly between 0.1 and 20 % by weight and more particularly between 0.5 and 20 % by weight, relative to the resin of the transparent conductive film.

The color and the luster of the conductive particles can be suitably selected according to the application. In a case of a display filter, conductive particles having a dark color such as black or brown and dull surfaces are preferable. In this case, the conductive particles can suitably adjust the light transmittance of the filter so as to make the display easy-to-see.

Such a transparent conductive layer on the base film may be made of tin indium oxide, zinc aluminum oxide, or the like by one of methods including vacuum evaporation, sputtering, ion plating, and CVD (chemical vapor deposit). In this case, when the thickness of the transparent conductive layer is less than 0.01 µm, sufficient electromagnetic-wave shielding efficiency can not be obtained, because the thickness of the conductive layer for the electromagnetic-wave shielding is too thin, and when exceeding 5 µm, light transparency may be spoiled.

Examples of matrix resin of the transparent conductive film include polyester, polyethylene terephthalate (PET), polybutylene terephthalate, polymethyl methacrylate (PMMA), acrylic board, polycarbonate (PC), polystyrene, triacetate film, polyvinyl alcohol, polyvinyl chloride, polyvinylidene chloride, polyethylene, ethylene-vinyl acetate copolymer, polyvinylbutyral, metal ionic cross-linked ethylene-methacrylic copolymer, polyurethane, and cellophane. Preferably selected from the above resins are PET, PC, and PMMA.

The thickness of the transparent conductive film is normally in a range from 1 µm to 5 mm.

By adding the transparent conductive film, excellent electromagnetic-wave shielding efficiency can be obtained.

As the adhesive resin for bonding the transparent base plates 2A, 2B or the transparent base plate 2 and the PDP body 20 through the electromagnetic-wave shielding and heat ray blocking film 3, a transparent adhesive resin having elasticity is preferably used, for example, adhesive resins normally used as adhesives for laminated glasses. For example, copolymers of ethylene group, such as ethylene-vinyl acetate copolymer, ethylene-methyl acrylic copolymer, ethylene(meth) acrylic copolymer, ethylene-ethyl (meth) acrylic copolymer, ethylene-methyl (meth) acrylic copolymer, metal ionic cross-linked ethylene-(meth) acrylic copolymer, partial saponified ethylene-vinyl acetate copolymer, calboxylated ethylene-vinyl acetate copolymer, ethylene-(meth) acrylic-maleic anhydride copolymer, and ethylene-vinyl acetate-(meth) acrylate copolymer. It should be noted that "(meth) acrylic" means "acrylic or methacrylic". Besides the above resins, polyvinyl butyral (PVB) resin, epoxy resin, acrylic resin, phenol resin, silicon resin, polyester resin, or urethane resin may also be employed. The best one among them is ethylene-vinyl acetate copolymer (EVA) because it can offer the best balance of performance and can be easily handled. In terms of the impact resistance, the perforation resistance, the adhesive property, and the transparency, PVB resin often used for laminated safety glasses for automobile is also preferable.

It is preferable that the PVB resin contains polyvinyl acetal between 70 and 95 % by unit weight and polyvinyl acetate between 1 and 15 % by unit weight, and has an average degree of polymerization between 200 and 3000, preferably 300 and 2500. The PVB resin is used as resin composition containing plasticizer.

Examples of plasticizer in the PVB resin composition include organic plasticizers, such as monobasic acid ester and polybasic acid ester, and phosphoric acid plasticizers.

Preferable examples of such monobasic acid ester are ester as a result of reaction of organic acid, such as butyric acid, isobutyric acid, caproic acid, 2-ethylbutyric acid, heptoic acid, n-octyl acid, 2-ethylhexyl acid, pelargonic acid (n-nonyl acid), or decyl acid, and triethylene glycol and, more preferably, are triethylene-di-2-ethylbthyrate, triethylene glycol-di-2-ethylhexoate, triethylene glycol-di-caproate, and triethylene glycol-di-n-ocotoate. Ester of one of the above organic acids and tetraethylene glycol or tripropylene glycol may be also employed.

Preferable examples of plasticizers of polybasic acid ester group are ester of organic acid, such as adipic acid, sebacic acid, or azelaic acid. and straight chain like or brunch like alcohol with from 4 to 8 carbon atoms and, more preferably, are dibutyl sebacate, dioctyl acetate, and dibutyl carbitol adipate.

Examples of phosphoric acid plasticizers include tributoxyethyl phosphate, isodecyl phenyl phosphate, and tri-isopropyl phosphate.

Insufficient plasticizer in the PVB resin composition reduces the film-forming property, while excessive plasticizer spoils the durability during high temperature. Therefore, the amount of plasticizer in the PVB resin composition is between 5 and 50 parts by weight, preferably between 10 and 40 parts by weight, per 100 parts by weight of polyvinyl butyral resin.

The PVB resin composition may further include, in small amounts, stabilizer, antioxidant, and/or ultraviolet absorbing agent.

Hereinafter, the description will now be made as regard to the adhesive intermediate film according to the present invention, by means of an example using EVA as the adhesive resin.

EVA in which the contents of vinyl acetate is between 5 and 50 % by weight, preferably between 15 and 40 % by weight, is employed. Less than 5 % by weight of vinyl acetate interferes with the weatherability and the transparency, while exceeding 40 % by weight of vinyl acetate significantly reduces mechanical characteristics, makes the film forming difficult, and produce a possibility of blocking between films.

Suitably employed as the crosslinking agent when the EVA is crosslinked by heating is organic peroxide which is selected according to the temperature for sheet process, the temperature for crosslinking agent, and the storage stability. Examples of available peroxide includes 2,5-dimethylhexane-2,5-dihydro peroxide: 2,5-dimethyl-2,5-di (tert-butylperoxy)-hexane-3; di-tert-butyl peroxide; tert-butylcumyl peroxide; 2,5-dimethyl-2,5-di (tert-butyl-peroxy)-hexane; dicumyl peroxide; α,α'-bis (tert-butyl peroxy)-benzene; n-buthyl-4,4-bis (tert-butyl-peroxy)-valerate; 2,2-bis (tert-butyl-peroxy)-butane, 1,1-bis (tert-butyl-peroxy)cyclohexane; 1,1-bis (tert-butyl-peroxy)-3,3.5- trimethylcyclohexane; tert-butyl peroxy benzoate; benzoyl peroxide; tert-butyl peroxy acetate; 2,5-dimethyl-2,5-bis (tert-butyl-peroxy)-hexyne-3; 1,1-bis (tert-butyl-peroxy)-3,3,5-trimethylcyclohexane; 1,1-bis (tert-butyl-peroxy)-cyclohexane; methyl ethyl ketone peroxide; 2,5-dimethylhexyl-2,5-bis-peroxy-benzoate; tert-butyl-hydroperoxide; p-menthane hydroperoxide; p-chlorbenzoyl peroxide; tert-butyl peroxyisobutyrate; hydroxyheptyl peroxide; and chlorohexanon peroxide. These are used alone or in mixed state, normally less than 10 parts by weight, preferably from 0.1 to 10 parts by weight per 100 parts by weight of EVA.

The organic peroxide is normally mixed to the EVA by an extruder or a roll mill or may be added to the EVA film by means of impregnation by dissolving the peroxide into organic solvent, plasticizer, or vinyl monomer.

In order to improve the properties (such as mechanical strength, optical property, adhesive property, weatherability, blushing resistance, and crosslinking speed) of the EVA, a compound containing one selected from acryloxy group or methacryloxy group and one selected from allyl group may be added into the EVA. Such a compound used for this purpose is usually acrylic acid or methacrylic acid derivative, for example. ester or amide thereof. Examples of ester residues include alkyl group such as methyl, ethyl, dodecyl, stearyl, and lauryl and, besides such alkyl group, cycloxyhexyl group, tetrahydrofurfuryl group, aminoethyl group, 2-hydroethyl, 3-hydroxypropyl group, and 3-chloro-2-hydroxypropyl group. Ester with polyfunctional alcohol such as ethylene glycol, triethylene glycol, polyethylene glycol, trimethylolpropane, or pentaerythritol may be also employed. The typical one of such amide is diacetone acrylamide.

More concretely, examples includes compounds containing polyfunctional ester such as acrylic ester or methacrylate such as trimethylolpropane, pentaerythritol and glycerin, or allyl group such as triallyl cyanurate, triallyl isocyanurate, diallyl phthalate, diallyl isophthalate, and diallyl maleate. These are used alone or in the mixed state, normally from 0.1 to 2 parts by weight, preferably from 0.5 to 5 parts by weight per 100 parts by weight of EVA.

When the EVA is crosslinked by light, photosensitizer is used instead of the above peroxide, normally less than 10 parts by weight, preferably from 0.1 to 10 parts by weight per 100 parts by weight of EVA.

In this case, examples of available photosensitizer include benzoin; benzophenone; benzoin methyl ether; benzoin ethyl ether; benzoin isopropyl ether; benzoin isobutyl ether; dibenzyl; 5- nitroaniline; hexachlorocyclopentadiene; p-nitrodiphenyl; p-nitroaniline; 2,4,6-trinitroaniline; 1,2- benzanthraquinone; and 3-methyl-1,3-diazo-1,9-benzanthrone. These can be used either alone or in the mixed state.

In this case, silane coupling agent is further used as adhesive accelerator. Examples of the silane coupling agent include vinyltriethoxysilane, vinyl-tris (β-methoxyethoxy) silane, γ-methacryloxypropyl trimethoxy silane, vinyltriacetoxy silane, γ-glycidoxypropyltrimetoxysilane, γ-glycidoxypropyltrietoxysilane, β-(3,4-epoxycyclohexyl) ethyl trimethoxy silane, γ-chloropropyl methoxy silane, vinyltrichlorosilane, γ-mercaptopropyl trimethoxy silane, γ-aminopropyl triethoxy silane, and N- (β-aminoethyl)-γ-aminopropyl trimethoxy silane.

These are used alone or in the mixed state, normally from 0.001 to 10 parts by weight, preferably from 0.001 to 5 parts by weight per 100 parts by weight of EVA.

The adhesive intermediate films may further include, in small amounts, ultraviolet ray absorbing agent, infrared ray absorbing agent, antioxidant, and/or paint processing aid. For adjusting the color of the filter itself, the adhesive intermediate films may further include coloring agent such as dye and pigment, and/or filler such as carbon black, hydrophobic silica, and calcium carbonate.

It is also effective that the intermediate adhesive layers in sheet condition are surfaced by corona discharge process, low temperature plasma process, electron beam irradiation process, or ultraviolet irradiation process as measures of improving the adhesive property.

The intermediate adhesive layers according to the present invention can be manufactured for example, by first mixing the adhesive resin and the additives listed above, kneading them by an extruder or a roll, and after that, forming in a predetermined configuration by means of a film forming method such as calendering, rolling, T-die extrusion, or inflation. During the film formation, embossing is provided for preventing the blocking between sheets and facilitating the deaerating during compressed onto the transparent base plate.

The thickness of the adhesive layer consisting of the electromagnetic-wave shielding and heat ray blocking film, the near infrared ray blocking films 3, and adhesive intermediate films 4A, 4B can vary according to the application of the electromagnetic-wave shielding and light transmitting plate or the panel laminated plate and is normally between 2 jam and 2 mm. Therefore, each adhesive intermediate film 4A, 4B is formed to have such a thickness to make the adhesive layer having the aforementioned thickness.

To manufacture the electromagnetic-wave shielding and light transmitting plate 1 or the panel laminated plate 10 as shown in Fig. 1 or 2, the transparent base plate 2A, 2 on which anti-reflection film 5 is formed, the transparent base plate 2B of which periphery is painted with black border 6 or the PDP body 20, the electromagnetic-wave shielding and heat ray blocking film 3, the adhesive intermediate films 4A, 4B are first prepared. The electromagnetic-wave shielding and heat ray blocking film 3 sandwiched between the adhesive intermediate films 4A, 4B is interposed between the transparent base plate 2A and the transparent base plate 2B or between the transparent base plate 2 and the PDP body 20, compressed under the hardened condition of the intermediate films 4A, 4B, and then heated or irradiated to integrate them.

It should be noted that the electromagnetic-wave shielding and light transmitting plate shown in Fig. 1 and the panel laminated plate shown in Fig. 2 are just examples of the present invention, so the present invention is not limited to the illustrative examples. For example, the aforementioned multi-layered film as the electromagnetic-wave shielding and heat ray blocking layer may be formed directly on the surface of one or both of the transparent base plates or the bonded surface of the PDP body, instead of being formed as a separate member from the transparent base plates and interposed between the transparent base plates or between the transparent base plate and the PDP body.

As described above, the heat ray blocking film may be used together with a transparent conductive film. Further, a transparent conductive film may be formed directly on the surface of the transparent base plate or the front surface of the PDP body. The electromagnetic-wave shielding and light transmitting plate and the panel laminated plate may include the following transparent conductive film formed on the transparent base plates or the front surface of the PDP body:
(1) a metal film formed in a lattice or punching metal-like arrangement by coating a photo-resist, exposing a pattern, etching and then developing the desired pattern; and
(2) a printed film formed in a lattice or punching metal-like arrangement by printing conductive ink.

Either in the electromagnetic-wave shielding and light transmitting plate or in the panel laminated plate of the present invention, instead of the transparent conductive film, metallic foil which is formed in a lattice or punching metal-like arrangement by pattern etching may be bonded on the front surface of the transparent base plate or the PDP body. Further, there is no limitation in using a conductive mesh member.

The electromagnetic-wave shielding and light transmitting plate of the present invention can be suitably used as a front filter of PDP and a window of a place where a precision apparatus is installed, such as a hospital or a laboratory.

Hereinafter, the present invention will be described in detail with regard to examples and comparative examples.

Adhesive intermediate films and electromagnetic-wave shielding and heat ray blocking films used in Examples and Comparative Examples were made in a manner described bellow.

### [Preparation of Adhesive intermediate films]

Each adhesive resin film 4A, 4B, 4C was made in such a way that 1 part by weight of 1,1-bis (tert-butyl-peroxy)-3,3,5- trimethylcyclohexane (Perhexa 3M available from NOF Corporation), 0.1 part by weight of γ-methacryloxypropyl trimethoxy silane, 2 parts by weight of diallyl phthalate, and 0.5 part by weight of Sumisolve 130 (available from Sumitomo Chemical Company, Limited.) as ultraviolet absorbing agent were added into and mixed with 100 parts by weight of ethylene-vinyl acetate copolymer (Ultrasen 634 available from Tosoh Corporation: 26 % content of vinyl acetate, Melt index 4) and the resultant mixture was extruded by a 40 mm extruder so that an adhesive intermediate film having a thickness of 500 µm with the both surfaces being embossed was prepared.

### [Electromagnetic-wave shielding and heat ray blocking film 3A]

An electromagnetic-wave shielding and heat ray blocking layer was formed on a PET film having a thickness of 100 µm by alternatively laminating five ITO layers and four silver layers to make a nine-layered film as shown in Fig. 3 in such a manner that the thickness of the outermost ITO layer and the inner-most ITO layer is 200Å, the thickness of the intermediate ITO layer is 400Å, and the thickness of the silver is 50Å by using a magnetron sputtering method. In this manner, the electromagnetic-wave shielding and heat ray blocking film 3A was prepared.

### [Electromagnetic-wave shielding and heat ray blocking film 3B]

An electromagnetic-wave shielding and heat ray blocking layer was formed by first forming an ITO layer of 200Å in thickness on a PET film having a thickness of 100 µm by using a magnetron sputtering method, after that, alternatively laminating three Ag films of 50Å in thickness and three ITO films of 400Å in thickness further forming a TiN film of 130Å in thickness thereon and, after that, forming a ITO film of 200Å in thickness. In this manner, the electromagnetic-wave shielding and heat ray blocking film 3B was prepared.

### Example 1

Used as the front transparent base plate 2A was a glass plate having a thickness of 3.0 mm. An anti-reflection film (total thickness is about 2500Å) 5 made of SiO₂ / ITO / SiO₂ / ITO was formed on the surface of the transparent base plate 2A. Used as the rear transparent base plate 2B was a PET sheet having a thickness of 0.1 mm. The electromagnetic-wave shielding and heat ray blocking film 3 (3A) was sandwiched by two adhesive intermediate films 4A and 4B and was interposed between the transparent base plates 2A and 2B as shown in Fig. 1 to first form an assembled unit. The assembled unit was entered into a rubber bag. The rubber bag containing the assembled unit therein was then vacuumed to be deaerated and pre-compressed under the temperature at 90 °C for 10 minutes. After that, the object thus pre-compressed was entered into an oven and heated at 150 °C for 15 minutes so that it is crosslinked and hardened to be integrated.

The resultant plate was measured for its electromagnetic-wave shielding efficiency in a range from 30 MHz to 300 MHz, its light transmittance, and its heat ray blocking efficiency in the following manner. The results are tabulated in Table 1.

### [Electromagnetic-wave shielding efficiency]

The attenuance of field of a sample was measured using EMI shield measuring equipment (MA8602B) available from Anritsu Corporation in conformity with KEC measurement (Kansai Electronic Industrial Promotion Center). The size of the sample was 90 mm %110 mm.

### [Light transmittance (%)]

The average visible light transmittance in a range between 380nm and 780 nm was measured using a visible ultraviolet spectrophotometer (U-4000) available from Hitachi Ltd.

### [Heat ray blocking efficiency]

The average near infrared light transmittance in a range between 850nm and 1100 nm was measured using a visible ultraviolet spectrophotometer (U-4000) available from Hitachi Ltd.

### Comparative Examples 1-3

For comparison, electromagnetic-wave shielding and heat ray blocking films were made in the same manner as Example 1 except that ITO films and Ag films were alternatively laminated in five layers, seven layers, and eleven layers. By using these films, plates of Comparative Examples were made in the same manner of Example 1. The plates were evaluated and the results are shown in Table 1.

**Table 1**

| Example & Comparative Examples | | Number of layers in electromagnetic-wave shielding and heat ray blocking film | Electromagnetic-wave shielding efficiency | | | Light transmittance (%) | Heat ray blocking (%) |
|---|---|---|---|---|---|---|---|
| | | | 30MHz | 100MHz | 300MHz | | |
| Example | 1 | NINE | 70 | 68 | 63 | 65 | 15 |
| Comparative Examples | 1 | FIVE | 65 | 62 | 56 | 73 | 33 |
| | 2 | SEVEN | 68 | 64 | 58 | 69 | 24 |
| | 3 | ELEVEN | 75 | 71 | 67 | 59 | 8 |

From Table 1, it is found that the electromagnetic-wave shielding and heat ray blocking film of nine laminated layers can obtain good characteristics in all of the transparency, the electromagnetic-wave shielding efficiency, and the heat ray blocking efficiency.

As apparent from the above results, according to the first and second aspects of the present invention, an electromagnetic-wave shielding and light transmitting plate which is industrially useful as a filter for a PDP and has high transparency, significantly improved electromagnetic-wave shielding capability, and heat ray blocking capability can be provided and a panel laminated plate made by integrating such an electromagnetic-wave shielding and light transmitting plate and a PDP can be provided.

### Example 2

Used as the front transparent base plate 2A was a glass plate having a thickness of 3.0 mm. An anti-reflection film (total thickness is about 2500Å) 5 made of SiO₂ / ITO / SiO₂ / ITO was formed on the surface of the transparent base plate 2A. Used as the rear transparent base plate 2B was a PET sheet having a thickness of 0.1 mm. The electromagnetic-wave shielding and heat ray blocking film 3 (3B) was sandwiched by two adhesive intermediate films 4A and 4B and was interposed between the transparent base plates 2A and 2B as shown in Fig. 1 to first form an assembled unit. The assembled unit was entered into a rubber bag. The rubber bag containing the assembled unit therein was then vacuumed to be deaerated and pre-compressed under the temperature at 90 °C for 10 minutes. After that, the object thus pre-compressed was entered into an oven and heated at 150 °C for 15 minutes so that it is crosslinked and hardened to be integrated.

The resultant plate was measured for its electromagnetic-wave shielding efficiency in a range from 30 MHz to 300 MHz, its light transmittance, and its heat ray blocking efficiency in the same manner as Example 1. At the same time, its reflectance in a range between 380 nm and 780 nm was measured using a 5 degree specular refrectance of the above visible ultraviolet spectrophotometer (U-4000) available from Hitachi Ltd. Each of measured values was tranformed to a luminous reflectance, and a mean value thereof was calculated.

Results are tabulated in Table 2.

In Table 2, results of Example 1 are also shown for the comparison.

**Table 2**

| Examples | Structure of electromagnetic-wave shielding and heat ray blocking film | Electromagnetic-wave shielding efficiency (dB) | | | Light transmittance (%) | Heat ray blocking (%) | Reflectance (%) |
|---|---|---|---|---|---|---|---|
| | | 30MHz | 100MHz | 300MHz | | | |
| Example 2 | Seven-layered film of ITO and Ag, with TiN and ITO | 68 | 66 | 62 | 62 | 18 | 2 |
| Example 1 | Nine-layered film of ITO and Ag | 70 | 68 | 63 | 65 | 15 | 7 |

From Table 2, it is found that the electromagnetic-wave shielding and heat ray blocking film with a TiN film can obtain significantly low reflectance, but the transparency, the electromagnetic-wave shielding efficiency, and the heat ray blocking efficiency are slightly worse than those of Example 1.

As apparent from the above results, according to the third and fourth aspects of the present invention, an electromagnetic-wave shielding and light transmitting plate which is industrially useful as a filter for a PDP and has low reflectance and high transparency, significantly improved electromagnetic-wave shielding capability, and heat ray blocking capability can be provided and a panel laminated plate made by integrating such an electromagnetic-wave shielding and light transmitting plate and a PDP can be provided.

## Claims

1. An electromagnetic-wave shielding and light transmitting plate comprising two transparent base plates and an electromagnetic-wave shielding and heat ray blocking layer interposed between the transparent base plates and integrally bonded together by transparent adhesives, wherein
said electromagnetic-wave shielding and heat ray blocking layer is a nine-layered film made by alternately laminating oxide transparent conductive films and metal thin films in which the top layer is one of the oxide transparent conductive films.

2. An electromagnetic-wave shielding and light transmitting plate as claimed in claim 1, wherein interposed between the two transparent base plates is an electromagnetic-wave shielding and heat ray blocking film made by forming the electromagnetic-wave shielding and heat ray blocking layer on a base film.

3. An electromagnetic-wave shielding and light transmitting plate as claimed in claim 1, wherein said transparent adhesives are transparent elastic adhesives.

4. A panel laminated plate comprising a plasma display panel body, a transparent base plate, and an electromagnetic-wave shielding and heat ray blocking layer interposed between the front surface of the plasma display panel body and the transparent base plate and integrally bonded together by transparent adhesives, wherein
said electromagnetic-wave shielding and heat ray blocking layer is a nine-layered film made by alternately laminating oxide transparent conductive films and metal thin films in which the top layer is one of the oxide transparent conductive films.

5. A panel laminated plate as claimed in claim 4, wherein interposed between the plasma display panel body and the transparent base plate is an electromagnetic-wave shielding and heat ray blocking film made by forming the electromagnetic-wave shielding and heat ray blocking layer on a base film.

6. A panel laminated plate as claimed in claim 4, wherein said transparent adhesives are transparent elastic adhesives.

7. An electromagnetic-wave shielding and light transmitting plate comprising two transparent base plates and an electromagnetic-wave shielding and heat ray blocking layer interposed between the transparent base plates and integrally bonded together by transparent adhesives, wherein
said electromagnetic-wave shielding and heat ray blocking layer comprises a multi-layered film, made by alternately laminating oxide transparent conductive films and metal thin films in such a manner that the front-most layer of the resultant plate is one of the oxide transparent conductive films, in addition, a titanium nitride film formed on the multi-layered film, and further another oxide transparent conductive film formed on the titanium nitride film.

8. An electromagnetic-wave shielding and light transmitting plate as claimed in claim 7, wherein interposed between the two transparent base plates is an electromagnetic-wave shielding and heat ray blocking film made by forming the electromagnetic-wave shielding and heat ray blocking layer on a base film.

9. An electromagnetic-wave shielding and light transmitting plate as claimed in claim 7, wherein said transparent adhesives are transparent elastic adhesives.

10. A panel laminated plate comprising a plasma display panel body, a transparent base plate, and an electromagnetic-wave shielding and heat ray blocking layer interposed between the front surface of the plasma display panel body and the transparent base plate and integrally bonded together by transparent adhesives, wherein
said electromagnetic-wave shielding and heat ray blocking layer comprises a multi-layered film, made by alternately laminating oxide transparent conductive films and metal thin films in such a manner that the front-most layer of the resultant plate is one of the oxide transparent conductive films, in addition, a titanium nitride film formed on the multi-layered film, and further another oxide transparent conductive film formed on the titanium nitride film.

11. A panel laminated plate as claimed in claim 10, wherein interposed between the plasma display panel body and the transparent base plate is an electromagnetic-wave shielding and heat ray blocking film made by forming the electromagnetic-wave shielding and heat ray blocking layer on a base film.

12. A panel laminated plate as claimed in claim 10, wherein said transparent adhesives are transparent elastic adhesives.
